# EUROPÄISCHE PATENTSCHRIFT

(11) **EP 0 423 582 B1**
(45) Veröffentlichungstag und Bekanntmachung des Hinweises auf die Patenterteilung: **10.01.1996**
(21) Anmeldenummer: 90119275.7
(22) Anmeldetag: 08.10.1990
(51) Int. Cl.: H03G 3/20, H04L 5/14

(54) **Verfahren zur Verstärkung eines Burst-Signals**
Method of amplification for burst-signals
Procédé d'amplification d'un signal en salve

(30) Priorität: 14.10.1989 DE 3934384
(43) Veröffentlichungstag der Anmeldung: 24.04.1991
(73) Patentinhaber: KE KOMMUNIKATIONS-ELEKTRONIK GMBH & CO, D-30179 Hannover (DE)
(72) Erfinder: Brahms, Martin, Dipl.-Ing., D-30457 Hannover (DE); Hennig, Andreas, Dipl.-Ing., D-30827 Garbsen (DE); Timmermann, Andreas, Dipl.-Ing., D-30952 Ronnenberg (DE)
(74) Vertreter: Döring, Roger, Dipl.-Ing.

(56) Entgegenhaltungen:
- FR-A- 2 116 608
- GB-A- 427 525
- US-A- 4 371 842

## Beschreibung

Die Erfindung bezieht sich auf ein Verfahren zur Verstärkung eines Burst-Signals, welches einem regelbaren Verstärker zugeführt wird, dessen Ausgangssignal nach Abtrennung des Gleichanteils einem Komparator zugeführt wird, bei welchem die Ausgangsgröße des Komparators einem Integrator aufgegeben wird, dem andererseits eine Referenzspannung (UREF) zugeführt wird, und bei welchem der Verstärker durch den Integrator im Ausgleichssinne verstellt wird (US-A-4 371 842).

Ein derartiges Verfahren wird beispielsweise bei der bidirektionalen Übertragung nachrichtentechnischer Signale im Zeitgetrenntlageverfahren verwendet. Die Signale beider Übertragungsrichtungen werden dabei über den gleichen Signalweg geführt, der durch metallische Leiter oder Lichtwellenleiter gebildet sein kann. Zwischen den einzelnen Bursts, in denen der kontinuierliche Datenstrom zeitlich komprimiert enthalten ist, liegen relativ große zeitliche Abstände, die zur Übertragung der Bursts der Gegenrichtung vorgesehen sind. Es liegt beim Burstbetrieb also keine kontinuierliche, sondern eine stark diskontinuierliche Datensignalübertragung vor. Auch bei dieser Art der Signalübertragung müssen die Signale - die Bursts - in Regeneratoren und Empfängern von den dort installierten Amplitudenentscheidern einwandfrei weiterverarbeitet werden können.

Aus der eingangs erwähnten US-A-4 371 842 ist eine automatische Regelung eines Verstärkers bekannt, bei welcher an den Ausgang des Verstärkers ein Netzwerk angeschlossen ist, durch welches der Gleichanteil des am Ausgang des Verstärkers anstehenden Signals vollständig abgetrennt wird. Das so behandelte Signal wird einem Spitzenwertdetektor zugeführt, dessen Ausgangssignal zur Verstellung des Verstärkers verwendet wird.

Der Erfindung liegt die Aufgabe zugrunde, das eingangs geschilderte Verfahren so zu gestalten, daß auf einfache Weise eine möglichst große Augenöffnung der Bursts erzeugt werden kann.

Diese Aufgabe wird gemäß der Erfindung dadurch gelöst,
- daß ein Verstärker mit zwei symmetrischen Ausgängen verwendet wird, an denen zwei zueinander spiegelsymmetrische Ausgangs-Signale anstehen,
- daß die beiden Ausgangs-Signale des Verstärkers als Signale mit vorbestimmter Gleichspannungsdifferenz eingestellt werden,
- daß dem Komparator die arithmetischen Mittelwerte dieser beiden eingestellten Signale aufgegeben werden und
- daß der Verstärker bei einer Abweichung der beiden eingestellten Signale voneinander verstellt wird.

Bei diesem Verfahren wird zunächst, beispielsweise durch ein einfaches CR-Netzwerk, zwischen den beiden spiegelsymmetrischen Ausgangs-Signalen des Verstärkers eine definierte Gleichspannungsdifferenz festgelegt. Die Verstärkung der Signale wird nun so geregelt, daß die arithmetischen Mittelwerte der durch das CR-Netzwerk eingestellten Signale auf gleichem Potential liegen. Das ergibt eine maximale Augenöffnung der Bursts, so daß ein nachgeschalteter Amplitudenentscheider bestmöglich entscheiden kann. Es kann daher ein einfacher Amplitudenentscheider verwendet werden. Die Bildung der arithmetischen Mittelwerte der beiden eingestellten Signale ist beispielsweise unter Einsatz von Tiefpässen, bei denen es sich um einfache RC-Glieder handeln kann, ebenfalls sehr einfach. Über den Komparator und den nachgeschalteten Integrator wird der Verstärker ohne großen Aufwand ständig im Ausgleichssinne verstellt, so daß dem Amplitudenentscheider stets Bursts mit maximaler Augenöffnung zugeführt werden. Trotz des diskontinuierlichen Betriebs ist so auf einfache Weise eine einwandfreie Verstärkung bzw. Regenerierung der Burst-Signale gewährleistet.

Vorteilhafte Ausgestaltungen der Erfindung gehen aus den Unteransprüchen hervor.

Das Verfahren nach der Erfindung wird im folgenden anhand der Zeichnungen beispielsweise erläutert.

Es zeigen:

Fig. 1 in schematischer Darstellung eine Schaltungsanordnung zur Durchführung des Verfahrens nach der Erfindung.
Fig. 2 einen Ausschnitt aus einem zu verarbeitenden Signal.
Fig. 3 die Signale hinter dem Verstärker in vergrößerter Darstellung.

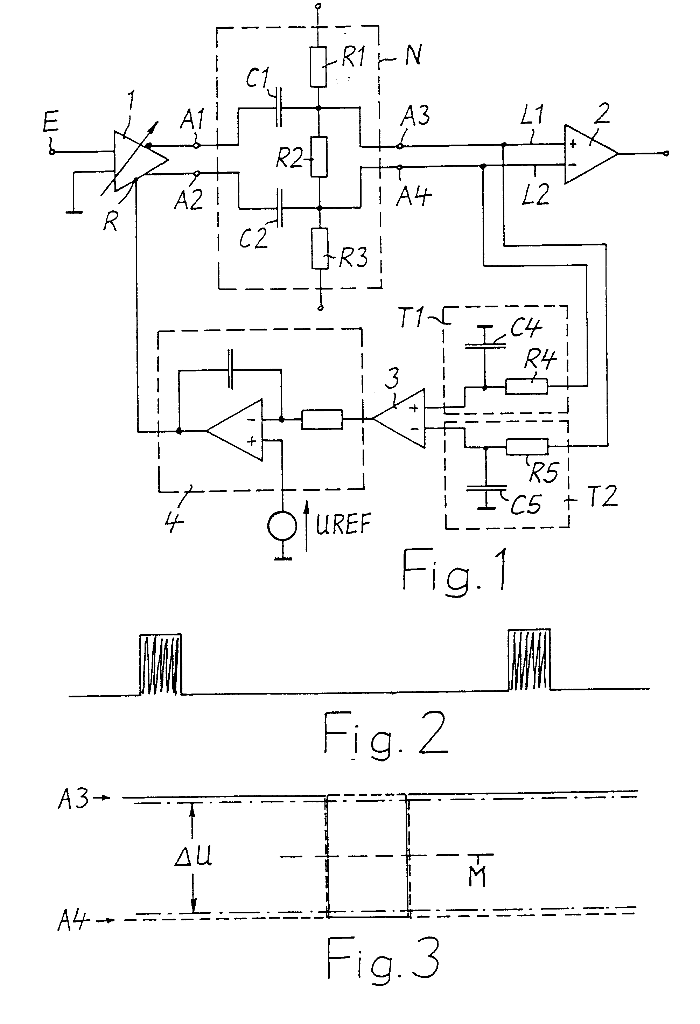

In Fig. 1 ist eine Schaltungsanordnung zur Verstärkung eines Burst-Signals in sehr einfacher Ausführungsform dargestellt, wobei nur die für das Verständnis der Erfindung erforderlichen Teile eingezeichnet sind.

Über einen Eingang E wird einem regelbaren Verstärker 1 ein Burst-Signal zugeführt, wie es ausschnittsweise prinzipiell aus Fig. 2 hervorgeht. Ein derartiges Burst-Signal wird bei der nachrichtentechnischen Übertragung insbesondere im sogenannten Zeitgetrenntlageverfahren verwendet, bei dem in den Pausen zwischen zwei Bursts der einen Übertragungsrichtung die Bursts der anderen Richtung über den gleichen Signalweg übertragen werden. Die Pausen zwischen den Bursts sind im Verhältnis zur zeitlichen Länge der Bursts sehr lang, so daß sich insgesamt ein stark diskontinuierliches Datensignal ergibt. Das verstärkte Burst-Signal wird einem Amplitudenentscheider (Komparator) 2 zugeführt.

Der regelbare Verstärker 1 hat einen Regeleingang R und zwei symmetrische bzw. komplementäre Ausgänge A1 und A2, an denen im Betriebsfall zwei zueinander spiegelsymmetrische, wechselspannungsmäßig inverse Signale verstärkt anstehen. Mit einem aus den Kondensatoren C1 und C2 sowie den Widerständen R1, R2 und R3 bestehenden, gestrichelt umrandeten CR-Netzwerk N wird für die beiden Ausgangs-Signale eine definierte Gleichspannungsdifferenz gebildet. Dadurch werden die arithmetischen Mittelwerte bzw. Nullinien der beiden Ausgangs-Signale einander in bestimmter Weise zugeordnet. Die Nullinien der beiden Ausgangs-Signale des Verstärkers 1 sind in Fig. 3 strichpunktiert eingezeichnet. Die zwischen ihnen bestehende Potentialdifferenz ist mit △U bezeichnet. An den Ausgängen A3 und A4 des CR-Netzwerks N stehen damit Signale an, die durch Festlegung ihrer Nullinien eine vorgegebene Lage bzw. einen vorgegebenen Abstand voneinander haben, so daß sie überlagert werden können. Die bei A3 und A4 anliegenden Signale werden im folgenden als "eingestellte Signale" bezeichnet.

Die eingestellten Signale werden auf den Leitungen L1 und L2 getrennt geführt und dem Amplitudenvergleicher 2 aufgegeben. Sie werden außerdem getrennt abgegriffen und zur Bildung ihrer arithmetischen Mittelwerte Tiefpässen T1 und T2 zugeführt. Mit der in Fig. 1 dargestellten Schaltung werden für die Bildung der Mittelwerte nur die Bursts der Signale ohne die zwischen den Bursts liegenden Pausen verwendet. Im vorliegenden Fall sind als Tiefpässe T1 und T2 RC-Glieder eingesetzt, mit den Widerständen R4 und R5 sowie den Kondensatoren C4 und C5. Es könnten aber auch LR-Glieder oder aktive Integratoren eingesetzt werden.

Die Mittelwerte der beiden eingestellten Signale werden einem Komparator 3 zugeführt, der diese Mittelwerte bzw. ihre Lage zueinander vergleicht. An den Komparator 3 ist ein Integrator 4 mit einem Eingang angeschlossen, dem über einen anderen Eingang eine Referenzspannung UREF zugeführt wird. Der Ausgang des Integrators 4 ist mit dem Regeleingang R des Verstärkers 1 verbunden. Bei einer Abweichung der Mittelwerte der eingestellten Signale voneinander wird der Verstärker 1 über den Integrator 4 im Ausgleichssinne verstellt. Das bedeutet, daß zur Erzielung einer möglichst großen Augenöffnung der zum Amplitudenentscheider 2 gelangenden Bursts die Mittelwerte der beiden eingestellten Signale auf der in Fig. 3 gestrichelt eingezeichneten Linie M liegen.

Zur Bildung der Mittelwerte der beiden eingestellten Signale werden - wie beschrieben - in bevorzugter Ausführungsform nur die Bursts selbst benutzt. Die Mittelwertbildung wird dadurch unabhängig von der zeitlichen Länge der Bursts und der Burstpausen. Wenn für die Mittelwertbildung das gesamte Burst-Signal verwendet wird, müssen zusätzlich zumindest auch der Spitzenwert (Amplitude) der Bursts und das Burst/Pausen-Verhältnis berücksichtigt werden.

## Patentansprüche

1. Verfahren zur Verstärkung eines Burst-Signals, welches einem in seiner Verstärkung regelbaren Verstärker (1) zugeführt wird, dessen Ausgangssignal nach Abtrennung des Gleichanteils einem Komparator (3) zugeführt wird, bei welchem die Ausgangsgröße des Komparators (3) einem Integrator (4) aufgegeben wird, dem andererseits eine Referenzspannung (UREF) zugeführt wird und bei welchem der Verstärker (1) durch den Integrator (4) im Ausgleichssinne verstellt wird, dadurch qekennzeichnet,
- daß ein Verstärker (1) mit zwei symmetrischen Ausgängen (A1,A2) verwendet wird, an denen zwei zueinander spiegelsymmetrische Ausgangs-Signale anstehen,
- daß die beiden Ausgangs-Signale des Verstärkers (1) als Signale mit vorbestimmter Gleichspannungsdifferenz (△U) eingestellt werden,
- daß dem Komparator (3) die arithmetischen Mittelwerte dieser beiden eingestellten Signale aufgegeben werden und
- daß der Verstärker (1) bei einer Abweichung der beiden eingestellten Signale voneinander in seiner Verstärkung verändert wird.

2. Verfahren nach Anspruch 1, dadurch gekennzeichnet, daß zur Bildung der Mittelwerte der beiden eingestellten Signale nur die Bursts selbst ohne die zwischen denselben liegenden Burst-Pausen verwendet werden.

3. Schaltungsanordnung zur Durchführung des Verfahrens nach Anspruch 1 oder 2, dadurch gekennzeichnet,
- daß an die beiden symmetrischen Ausgänge (A1,A2) des geregelten Verstärkers (1) ein CR-Netzwerk (N) angeschlossen ist, dem die beiden spiegelsymmetrischen Ausgangs-Signale des Verstärkers (1) getrennt zugeführt werden,
- daß die beiden Ausgänge (A3,A4) des CR-Netzwerks (N) jeweils über einen Tiefpaß (T1,T2) mit je einem Eingang eines Komparators (3) verbunden sind,
- daß der Ausgang des Komparators (3) mit einem Eingang eines Integrators (4) verbunden ist, an den über einen anderen Eingang eine Referenzspannung (UREF) angeschlossen ist, und
- daß der Ausgang des Integrators (4) mit dem Regeleingang (R) des Verstärkers (1) verbunden ist.

4. Schaltungsanordnung nach Anspruch 3, dadurch gekennzeichnet, daß als Tiefpässe (T1,T2) RC-Glieder verwendet werden.

## Claims

1. Method for amplifying a burst signal, which is supplied to a variable gain amplifier (1) whose output signal is supplied to a comparator (3) after separation of the DC element, in which method the output variable of the comparator (3) is passed to an integrator (4) to which, on the other hand, a reference voltage (UREF) is supplied and in which method the amplifier (1) is adjusted by the integrator (4) in the sense of tuning it, characterized
- in that an amplifier (1) having two symmetrical outputs (A1,A2) is used, at which outputs two output signals are present which are in mirror-image symmetry with respect to one another,
- in that the two output signals of the amplifier (1) are set as signals having a predetermined DC voltage difference (ΔU),
- in that the arithmetic means of these two set signals are passed to the comparator (3) and
- in that the gain of the amplifier (1) is varied in the event of any discrepancy between the two set signals from one another.

2. Method according to Claim 1, characterized in that only the bursts themselves, without the burst pauses located between them, are used to form the mean values of the two set signals.

3. Circuit arrangement for carrying out the method according to Claim 1 or 2, characterized
- in that a CR network (N) is connected to the two symmetrical outputs (A1,A2) of the regulated amplifier (1) , to which CR network (N) the two output signals, which are in mirror-image symmetry, of the amplifier (1) are separately supplied,
- in that the two outputs (A3,A4) of the CR network (N) are each connected via a low-pass filter (T1,T2) to in each case one input of a comparator (3),
- in that the output of the comparator (3) is connected to an input of an integrator (4) to which a reference voltage (UREF) is connected via another input, and
- in that the output of the integrator (4) is connected to the regulating input (R) of the amplifier (1).

4. Circuit arrangement according to Claim 3, characterized in that RC elements are used as low-pass filters (T1,T2).

## Revendications

1. Procédé pour amplifier un signal en salves, qui est amené à un amplificateur réglable (1) quant à son amplification, dont le signal de sortie, après séparation de la fraction continue, est amené à un comparateur (3j, dans le cas duquel la grandeur de sortie du comparateur (3) est délivrée à un intégrateur (4), auquel est par ailleurs amenée une tension de référence (UREF) et dans le cas duquel l'amplificateur (1) est décalé par l'intégrateur (4) dans le sens de l'équilibre, procédé caractérisé en ce que :
- l'on utilise un amplificateur (1) avec deux sorties symétriques (A1,A2), sur lesquelles sont appliqués deux signaux de sortie symétriques l'un par rapport à l'autre,
- les deux signaux de sortie de l'amplificateur (1) sont réglés comme des signaux ayant une différence de tension continue prédéterminée (△U),
- l'on délivre au comparateur (3) les valeurs moyennes arithmétiques de ces deux signaux réglés et
- l'on fait varier l'amplificateur (1) quant à son amplification dans le cas où il y a un écart entre les deux signaux réglés l'un par rapport à l'autre .

2. Procédé selon la revendication 1, caractérisé en ce que pour former les valeurs moyennes des deux signaux réglés on utilise seulement les salves elles-mêmes sans les pauses qui se trouvent entre celles-ci.

3. Circuit pour la mise en oeuvre du procédé selon la revendication 1 ou 2, caractérisé en ce que :
- l'on raccorde aux deux sorties symétriques (A1, A2) de l'amplificateur réglé (1) un réseau CR, désigné par la référence (N), auquel sont amenés séparément les deux signaux de sortie symétriques de l'amplificateur (1),
- les deux sorties (A3,A4) du réseau CR désigné par la référence (N) sont respectivement reliées par l'intermédiaire d'un filtre passe-bas (T1,T2) chacune à une entrée d'un comparateur (3),
- la sortie du comparateur (3) est reliée à une entrée d'un intégrateur(4), auquel est raccordé par une autre entrée une tension de référence (UREF) et
- la sortie de l'intégrateur (4) est reliée à l'entrée de réglage (R) de l'amplificateur (1).

4. Circuit selon la revendication 3, caractérisé en ce que l'on utilise comme filtres passe-bas (T1,T2) des éléments RC (résistances, capacités ).
